# EUROPÄISCHE PATENTANMELDUNG

(11) **EP 1 748 484 A2**
(43) Veröffentlichungstag der Anmeldung: **31.01.2007**
(21) Anmeldenummer: 06013708.0
(22) Anmeldetag: 03.07.2006
(51) Int. Cl.: H01L 23/473

(54) **Vorrichtung zur Kühlung von elektronischen Bauelementen**

(30) Priorität: 27.07.2005 DE 102005034998
(71) Anmelder: Behr Industry GmbH & Co. KG, 70469 Stuttgart (DE)
(72) Erfinder: Flesch, Markus, 70806 Kornwestheim (DE); Klenk, Andreas, 71640 Ludwigsburg (DE); Siebrecht, Thomas, 71642 Ludwigsburg (DE)

(57) **Zusammenfassung**

Die Erfindung betrifft eine Vorrichtung (1) zur Kühlung von elektronischen Bauelementen (2, 3, 4), im Wesentlichen bestehend aus plattenförmigen Bauteilen, welche einen von einem flüssigen Kühlmittel durchströmbaren Strömungskanal bilden.

Es ist vorgesehen, dass zwischen den plattenförmigen Bauteilen mindestens ein plattenförmiges, Ausschnitte (9, 10, 11) aufweisendes Rahmenelement (8) angeordnet ist, wobei die Ausschnitte (9, 10, 11) als Strömungskanalabschnitte ausgebildet sind.

## Beschreibung

Die Erfindung betrifft eine Vorrichtung zur Kühlung von elektronischen Bauelementen nach dem Oberbegriff des Patentanspruches 1 - bekannt durch die DE 41 31 739 A1 der Anmefderin,

Die bekannte Kühleinrichtung für elektrische Bauelemente besteht im Wesentlichen aus zwei plattenförmigen Bauteilen, einer Grundplatte und einer Deckplatte, welche zwischen sich einen Hohlraum einschließen, der von einem flüssigen Kühlmittel durchströmbar ist. Zur Verbesserung des Wärmeüberganges ist in dem als Strömungskanal fungierenden Hohlraum eine Turbulenzeinlage angeordnet. Die elektrischen Bauelemente sind wärmeleitend auf der Grundplatte angeordnet und geben ihre Verlushnrärme über die Grundplatte an das Kühlmittel ab. Die Herstellung der bekannten Kühleinrichtung ist mit relativ hohen Kosten verbunden, da der Hohlraum durch spangebende Bearbeitung (Fräsen) der Grundplatte hergestellt und durch eine mit der Grundplatte verschraubte Deckplatte abgedichtet wird. Darüber hinaus kann sich - je nach Anordnung und Verlustleistung der elektronischen Bauelemente - ein inhomogener Wärmeeintrag für die Grundplatte ergeben, was zu unterschiedlichen Temperaturen (inhomogene Temperaturverteilung) und auch zu so genannten hot spots (heißen Stellen) führen kann. Eine effektive Kühlung der elektronischen Bauelemente ist unter diesen Umständen nicht möglich.

Durch die DE 199 11 205 A1 wurde eine Kühlvorrichtung für elektronische Bauelemente mit zwei plattenförmigen Bauteilen, einer Metallplatte und einem Kunststoffkasten, bekannt, welche einen U-förmig verlaufenden Strömungskanal bilden. Dazu weist der Kunststoffkasten einen Trennsteg auf, welcher den gesamten Hohlraum zwischen beiden Platten in zwei Teilräume mit einer Umlenkung unterteilt. Dadurch wird zwar eine verbesserte Kühlung erreicht, jedoch ergeben sich auch hier die gleichen Nachteile bezüglich der Herstellungskosten und einer Überhitzung bei inhomogenem Wärmeeintrag durch die elektronischen Bauelemente.

Es ist Aufgabe der vorliegenden Erfindung, eine Vorrichtung zur Kühlung von elektronischen Bauelementen der eingangs genannten Art in ihrer Effizienz zu verbessern sowie bezüglich ihrer Herstellungskosten und des Bauraumes zu reduzieren.

Diese Aufgabe wird durch die Merkmale des Patentanspruches 1 gelöst. Erfindungsgemäß ist vorgesehen, dass zwischen den plattenförmigen Bauteilen mindestens ein plattenförmiges Rahmenelement mit Ausschnitten angeordnet ist, wobei die Ausschnitte Abschnitte eines Strömungskanals bilden. Die Ausschnitte sind somit kühlmittelseitig miteinander verbunden, wobei sie hintereinander und/oder parallel zueinander geschaltet sein können. Die Ausschnitte weisen im Prinzip eine beliebige Form auf, und sind bezüglich Form und Anordnung an die elektronischen Bauelemente angepasst, welche auf der Kühlvorrichtung angeordnet sind. Vorteilhafterweise sind in den Ausschnitten Turbulenzeinlagen angeordnet, welche durch die Ausschnitte positioniert werden und den Wärmeübergang an das Kühlmittel verbessern. Das plattenförmige Rahmenelement und die plattenförmigen Bauteile werden vorzugsweise durch Löten miteinander verbunden, wozu plattenförmige Lotträger verwendet werden. Vorteilhaft bei dieser Bauweise ist der einfache Aufbau durch Stapeln und Verlöten von plattenförmigen Bauteilen. Eine Verschraubung und mechanische Abdichtungen zwischen den Platten entfallen somit.

Nach einer besonders vorteilhaften Ausgestaltung der Erfindung werden die Ausschnitte in dem plattenförmigen Rahmenelement durch Laserschneiden oder Wasserstrahlschneiden hergestellt. Dies hat den Vorteil, dass einerseits beliebige Konturen für die Ausschnitte, d. h. die Strömungskanäle herstellbar sind und dass andererseits eine saubere (spanlose) und kostengünstige Fertigung erreicht wird. Das erfindungsgemäße Rahmenelement kann in beliebiger Wandstärke, welche auch der Höhe der Turbulenzeinlagen entspricht, hergestellt werden, und zwar aus einem kostengünstigen Halbzeugmaterial. Möglich ist auch die Verwendung von mehreren, gleichen, aufeinander geschichteten Rahmenelementen zur Erzielung einer größeren Strömungskanalhöhe.

Nach einer weiteren vorteilhaften Ausgestaltung der Erfindung ist dem Rahmenelement ein Zwischenelement mit Aussparungen zugeordnet, welche als Verteiler- oder Sammelkanäle für die Strömungskanäle im Rahmenelement dienen. Durch diese Zwischenplatte können der Zustrom und der Abstrom des Kühlmittels verbessert und die Strömungsgeschwindigkeit des Kühlmittels niedrig gehalten bzw. zu hohe Strömungsgeschwindigkeiten vermieden werden. Das Zwischenelement ist mit dem Rahmenelement und den plattenförmigen Bauteilen ebenfalls durch Löten stoffschlüssig verbunden. Auch die Ausschnitte für die Verteiler- bzw. Sammelkanäle können bevorzugt durch Laserschneiden und/oder Wasserstrahlschneiden hergestellt werden.

Nach einer weiteren vorteilhaften Ausgestaltung der Erfindung ist - zusätzlich zu dem ersten Rahmenelement - ein zweites Rahmenelement mit entsprechenden Ausschnitten vorgesehen, wodurch zusätzliche Strömungskanäle für das Kühlmittel geschaffen werden und damit zusätzliche Kühlkapazität bereitgestellt wird

In weiterer vorteilhafter Ausgestaltung der Erfindung können beide Seiten (Ober- und Unterseite) der Kühlvorrichtung als Kühlflächen ausgebildet und mit den elektronischen Bauelementen bestückt werden. Damit wird der' Vorteil einer erhöhten Kühlkapazität bei geringem Bauraum erreicht.

Ein Ausführungsbeispiel der Erfindung ist in der Zeichnung dargestellt und wird im Folgenden näher beschrieben. Es zeigen
- Fig. 1: eine erfindungsgemäße Kühlvorrichtung in Form einer Kühlplatte mit elektronischen Bauelementen,
- Fig. 2: die Kühlplatte gemäß Fig. 1 mit entfernter Deckplatte und
- Fig. 3: die erfindungsgemäße Kühlplatte in Explosivdarstellung vor ihrem Zusammenbau.

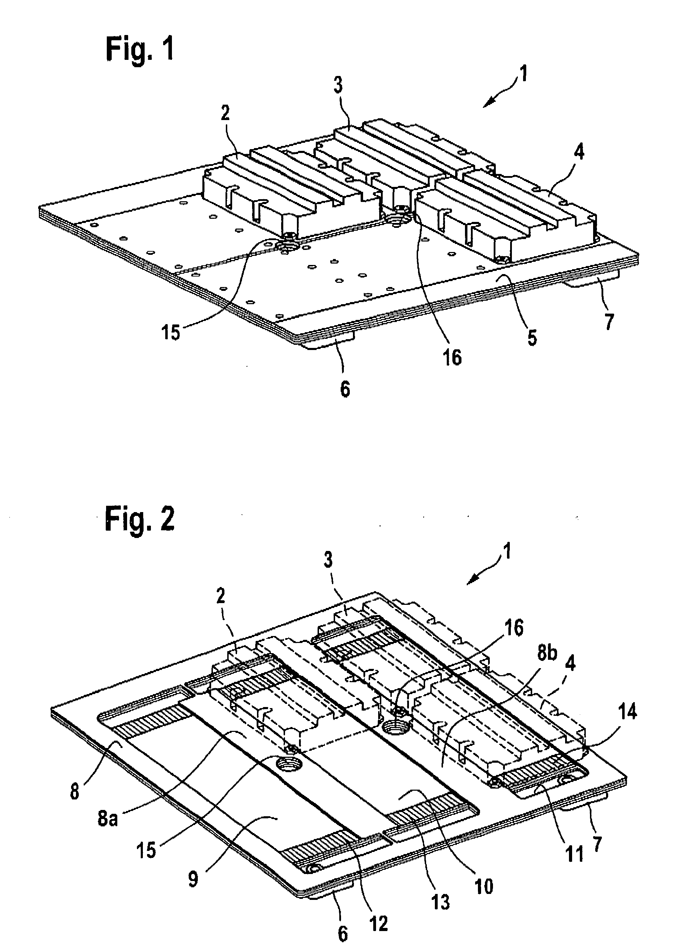

**Fig. 1** zeigt eine erfindungsgemäße Kühlvorrichtung für elektronische Bauelemente in Form einer Kühlplatte 1, auf welcher einzelne zu kühlende elektronische Bauelemente in Form von Leistungshalbleitern 2, 3, 4 angeordnet sind. Die Kühlplatte 1 ist sandwichartig aus mehreren Platten aufgebaut, wobei die oberste Platte als Deckplatte 5 und Kühlfläche ausgebildet ist, auf welcher die elektronischen Bauelemente 2, 3, 4 wärmeleitend befestigt sind. Auf der Unterseite der Kühlplatte 1 sind zwei Kühlmittelanschlüsse 6, 7 angeordnet, über welche ein flüssiges Kühlmittel, beispielsweise ein Wasser/Glykol-Gemisch zu- und abgeführt wird.

**Fig. 2** zeigt die Kühlplatte 1 mit entfernter Deckplatte 5, so dass ein plattenförmiges Rahmenelement 8 mit drei etwa rechteckförmig ausgebildeten Ausschnitten 9, 10, 11 sichtbar ist. Die Ausschnitte 9, 10, 11 dienen als Strömungskanäle für das flüssige Kühlmittel und nehmen - was nur teilweise dargestellt ist - Turbulenzeinlagen 12, 13, 14 in sich auf. Die Ausschnitte 9, 10, 11 sind in ihrer Anordnung und Form an die Leistungshalbleiter 2, 3, 4 angepasst, d. h. das flüssige Kühlmittel strömt an der Unterseite der Leistungshalbleiter 2, 3, 4 vorbei und kann damit die aufgenommene Verlustwärme direkt abführen. Die Ausschnitte bzw. Strömungskanäle können parallel und/oder hintereinander durchströmt werden: z. B. können die beiden ersten Strömungskanalabschnitte 9, 10 parallel vom in den Kühlmittelanschluss 6 eintretendes Kühlmittel durchströmt werden, während der dritte Strömungskanalabschnitt 11 anschließend mit der gesamten Kühlmittelmenge beaufschlagt wird, welche durch den Kühlmittelanschluss 7 abgeführt wird.

Das Rahmenelement 8 weist zwischen den Aussparungen 9, 10, 11 Stege 8a, 8b auf, in welchen Positionieröffnungen 15, 16 angeordnet sind, welche sich - wie auch Fig. 1 zeigt - durch die gesamte Kühlplatte 1 erstrecken. Die Positionieröffnungen 15, 16 dienen beim Zusammenbau der Kühlplatte 1 zur Positionierung der einzelnen plattenförmigen Bauteile und stellen somit vorzugsweise eine Montagehilfe dar.

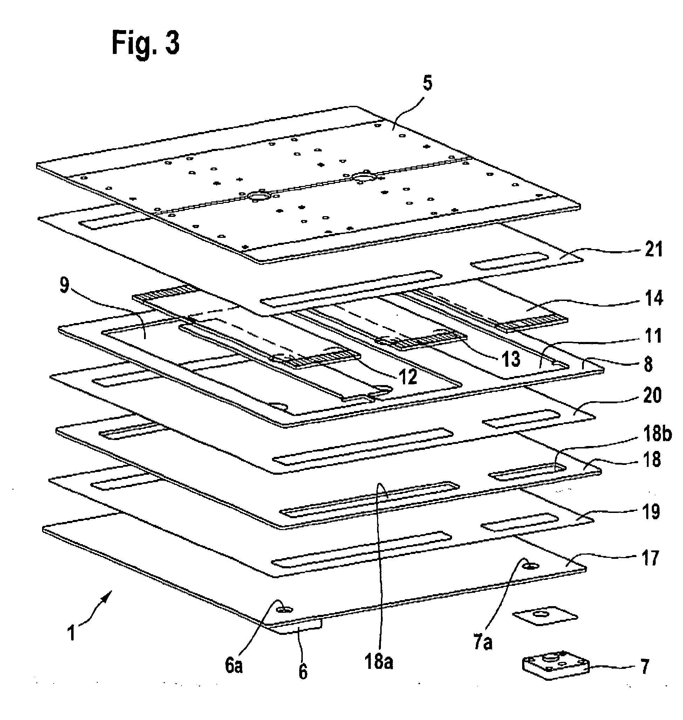

**Fig. 3** zeigt die Kühlplatte 1 gemäß Fig. 1 und 2 in Explosivdarstellung, d. h. mit ihren Einzelteilen vor der Montage. Für gleiche Teile werden gleiche Bezugszahlen verwendet. Die Kühlplatte 1 ist sandwichartig aus diversen plattenförmigen Elementen aufgebaut, wobei die Deckplatte 5 das oberste und eine Grundplatte 17 das unterste Plattenelement bilden. Zwischen Deckplatte 5 und Grundplatte 17 sind das plattenförmige Rahmenelement 8 sowie ein plattenförmiges Zwischenelement 18 angeordnet ist. Zwischen Grundplatte 17, Zwischenelement 18, Rahmenelement 8 und sowie Deckplatte 5 sind jeweils plattenförmige Lotträger 19, 20, 21 angeordnet, welche vorzugsweise aus einem beidseitig lotplattierten Trägerblech bestehen. An der Grundplatte 17, welche eine Eintrittsbohrung 6a und eine Austrittsbohrung 7a aufweist, werden die Kühlmittelanschlüsse 6, 7 befestigt. Die Turbulenzeinlagen 12, 13, 14 werden in die entsprechenden Ausschnitte 9, 10, 11 des Rahmenelementes 8 eingesetzt. Die plattenförmigen Elemente 5, 8, 18, 17 sind aus einer Aluminiumlegierung hergestellt und werden zusammen mit den Turbulenzeinlagen 12, 13, 14 und mittels der Lotträger 19, 20, 21 in einem nicht dargestellten Lötofen flussmittelfrei gelötet. Nach Fertigstellung der Lötung entsteht eine kompakte Kühlplatte 1 - wie in den Figuren 1 und 2 dargestellt.

Das plattenförmige Zwischenelement 18 weist zwei Ausschnitte 18a, 18b und - was auf der Zeichnung nicht erkennbar ist - weitere Ausschnitte auf der gegenüber liegenden Seite auf, welche als Sammel- und Verteilerkanäle für das Kühlmittel dienen. Die Kühlplatte 1 wird vom Kühlmittel bevorzugt wie folgt durchströmt: das flüssige Kühlmittel tritt über den Kühlmittelanschluss 6 ein und gelangt über die Bohrung 6a in der Grundplatte 17 in den Verteilausschnitt 18a, von wo aus es in die beiden Strömungskanalabschnitte 9, 10 eintritt und diese parallel durchströmt. Der Kühlmittelstrom wird dann - was in der Zeichnung nicht erkennbar ist - zusammengeführt und dem dritten Strömungskanalabschnitt 11 zugeführt. Das Kühlmittel tritt aus dem Ausschnitt 11 des Rahmenelementes 8 in den Sammelausschnitt 18b des Zwischenelementes 18 ein und gelangt dann über die Austrittsbohrung 7a in der Grundplatte 17 in den Kühlmittelaustritt 7. Abweichend vom dargestellten und beschriebenen Ausführungsbeispiel sind andere Durchströmungen der Kühlplatte 1, insbesondere des Rahmenelementes 8 möglich: beispielsweise können die drei Abschnitte sämtlich hintereinander oder parallel zueinander durchströmt werden. Darüber hinaus können die Abschnitte in Form und Zahl variiert und damit an die jeweilige Bestückung mit elektrischen Bauelementen angepasst werden.

Nach einem weiteren, nicht dargestellten Ausführungsbeispiel der Erfindung ist ein weiteres plattenförmiges Rahmenelement vorgesehen, d. h. zusätzlich zu dem in Fig. 3 dargestellten Rahmenelement 8. Dadurch können zusätzliche Kühlkanäle geschaffen und beide Abschlussplatten, nämlich die obere und die untere Platte als Kühlfläche genutzt und mit elektronischen Bauelementen bestückt werden. Damit wird eine erhöhte Kühlkapazität auf geringem Bauraum bereitgestellt.

## Patentansprüche

1. Vorrichtung zur Kühlung von elektronischen Bauelementen, im Wesentlichen bestehend aus plattenförmigen Bauteilen (5, 17), welche einen von einem flüssigen Kühlmittel durchströmbaren Strömungskanal bilden, **dadurch gekennzeichnet, dass** zwischen den plattenförmigen Bauteilen (5, 17) mindestens ein plattenförmiges, Ausschnitte (9, 10, 11) aufweisendes Rahmenelement (8) angeordnet ist, wobei die Ausschnitte (9, 10, 11) als Strömungskanalabschnitte ausgebildet sind.

2. Vorrichtung nach Anspruch 1, **dadurch gekennzeichnet, dass** innerhalb der Ausschnitte (9, 10, 11) Einrichtungen zur Turbulenzerzeugung (Turbulenzeinlagen 12, 13, 14) angeordnet sind.

3. Vorrichtung nach Anspruch 1 oder 2, **dadurch gekennzeichnet, dass** die Ausschnitte etwa rechteckförmig ausgebildet und kühlmittelseitig miteinander verbunden sind.

4. Vorrichtung nach Anspruch 1, 2 oder 3, **dadurch gekennzeichnet, dass** das Rahmenelement (8) eine Wandstärke aufweist, die der Höhe der Turbulenzeinlagen (12, 13, 14) entspricht.

5. Vorrichtung nach einem der Ansprüche 1 bis 4, **dadurch gekennzeichnet, dass** das Rahmenelement (8) und/oder die Turbulenzeinlagen (12, 13, 14) stoffschlüssig, insbesondere durch Löten mit den plattenförmigen Bauteilen (5, 17) verbunden sind.

6. Vorrichtung nach Anspruch 5, **dadurch gekennzeichnet, dass** zwischen dem Rahmenelement (8) und den plattenförmigen Bauteilen (5, 17) plattenförmige Lotträger (20, 21), insbesondere lotplattierte Bleche angeordnet sind.

7. Vorrichtung nach einem der Ansprüche 1 bis 6, **dadurch gekennzeichnet, dass** ein plattenförmiges Bauteil als Grundplatte (17) ausgebildet ist, an welcher Kühlmittelanschlüsse (6, 6a; 7, 7a) angeordnet sind.

8. Vorrichtung nach Anspruch 7, **dadurch gekennzeichnet, dass** zwischen Rahmenelement (8) und Grundplatte (17) ein plattenförmiges Zwischenelement (18) angeordnet ist, welches Verteiler- und/oder Sammelausschnitte (18a, 18b) aufweist, welche mit den Ausschnitten (9, 10, 11) des Rahmenelements (8) kommunizieren.

9. Vorrichtung nach einem der Ansprüche 1 bis 8, **dadurch gekennzeichnet, dass** die Ausschnitte (9, 10, 11) und/oder die Verteiler- sowie Sammelausschnitte (18a, 18b) durch Laserschneiden und/oder Wasserstrahlschneiden herstellbar sind.

10. Vorrichtung nach einem der Ansprüche 1 bis 9, **dadurch gekennzeichnet, dass** zusätzlich zu dem ersten Rahmenelement (8) ein zweites Rahmenelement zur Bildung eines zweiten Strömungskanals vorgesehen ist.

11. Vorrichtung nach Anspruch 10, **dadurch gekennzeichnet, dass** die plattenförmigen Bauelemente (5, 17) eine obere und eine untere Kühlfläche bilden und dass beide Kühlflächen mit elektronischen Bauelementen (2, 3, 4) bestückbar sind.
